**Europäisches Patentamt**

**European Patent Office**

**Office européen des brevets**

(19)

(11) **EP 1 580 899 A1**

(12) **EUROPEAN PATENT APPLICATION**

| | |
|---|---|
| (43) Date of publication:<br>**28.09.2005 Bulletin 2005/39** | (51) Int Cl.⁷: $H03M\ 13/15$, $G11B\ 20/18$, $H03M\ 13/29$ |

(21) Application number: **05006686.9**

(22) Date of filing: **06.07.2000**

| | |
|---|---|
| (84) Designated Contracting States:<br>**DE FR GB NL** | • **Kim, Myoung-June**<br>**Suwon-city Kyungki-do (KR)**<br>• **Park, In-sik**<br>**Kwonseon-gu Suwon-city Kyungki-do (KR)** |
| (30) Priority: **08.07.1999 KR 9927453** | |
| (62) Document number(s) of the earlier application(s) in accordance with Art. 76 EPC:<br>**00305708.0 / 1 067 695** | (74) Representative: **Brandon, Paul Laurence et al**<br>**APPLEYARD LEES,**<br>**15 Clare Road**<br>**Halifax HX1 2HY (GB)** |
| (71) Applicant: **SAMSUNG ELECTRONICS CO., LTD.**<br>**Gyeonggi-do (KR)** | Remarks:<br>This application was filed on 26 - 03 - 2005 as a divisional application to the application mentioned under INID code 62. |
| (72) Inventors:<br>• **Shim, Jae seong**<br>**Seoul (KR)** | |

(54) **Error correction method for high density disc**

(57) An error correction method for optical discs, and more particularly, an error correction method appropriate to high density discs is provided. The error correction method adding inner parity and outer parity to an error correction block with n byte x m x o size have the steps of obtaining a plurality of inner parity blocks (PI blocks) by segmenting the error correction block to the inner parity (PI) direction into x segments (here, x is an integer equal to or greater than 2); generating e-byte PI for each of the plurality of PI blocks generated by segmenting, and adding the PIs to the PI direction; and generating f-byte outer parity (PO) to the PO direction of the error correction block having PIs, and adding the POs to the PO direction. The error correction method maintains redundancy of parity signal in the similar level to the existing DVDs, while enhancing error correction capability.

## FIG. 3

EP 1 580 899 A1

**Description**

The present invention relates to an error correction method for optical discs, and more particularly, to an error correction method appropriate for high density discs.

There are currently a variety of optical discs available, including a compact disc (CD), a digital versatile disc (DVD), etc., and a high density DVD (HD-DVD), which requires higher density recording and reproducing than a DVD, is currently under development. While the existing DVD has a storage capacity of 4.7 GB, the HD-DVD has a storage capacity of equal to or greater than 15 GB. The higher storage capacity of the HD-DVD is implemented by reducing the diameter of a beam spot for data recording/reproducing and increasing the line density.

The amount of data affected by a defect in an HD-DVD is far greater than the amount of data affected by the same length defect in an existing DVD. Therefore, an HD-DVD requires stronger error correction than the existing DVD.

Figure 1 shows the structure of an error correction code (ECC) block in a conventional DVD. The error correction code block shown in Figure 1 has a 10-byte parity for error correction of 172 bytes of data in the row direction, as an inner parity (PI), and a 16-byte parity for error correction of 192 bytes of data in the column direction, as an outer parity (PO). Here, the capability of error correction by the PI is a maximum of 5 bytes, and that of PO is a maximum of 16 bytes for erasure correction.

Assuming that an HD-DVD uses the same error correction method as a DVD, the affect of a defect will now be explained in detail.

Figure 2 illustrates the relationship of a beam spot and an object lens in an optical disc.

Table 1 illustrates the relationships among t, the thickness of a disc, NA, the numerical aperture of an object lense, 2R, the diameter of a beam spot, and k, the length of a defect.

Table 1

| t | NA | R (mm) | 2R (mm) | Remark | k, length of defect |
|---|---|---|---|---|---|
| 0.6 | 0.6 | 0.248 | 0.496 | DVD | k + 2R |
| | 0.65 | 0.273 | 0.546 | | |
| 0.3 | 0.65 | 0.136 | 0.272 | | |
| | 0.85 | 0.193 | 0.286 | | |
| 0.2 | 0.85 | 0.129 | 0.258 | | |
| 0.1 | 0.7 | 0.049 | 0.098 | DVD/3.88 | |
| | 0.85 | 0.064 | 0.128 | | |

1) The effect of a large defect

Here, a large defect means a burst error which cannot be corrected by a PI, and is generated by a scratch, a finger print, a black dot, etc.

A defect which spans 5 bytes is a burst error which cannot be corrected by a PI. At this time, the length of a defect is

$$k = 5 \text{ bytes x } 16 \text{ channel bits x } 0.133 \text{ } \mu m \text{ (the length of 1}$$

$$\text{channel bit)} = 10.64 \text{ } \mu m$$

When a 20 GB HD-DVD is compared to a 4.7 GB DVD, the line density increase is $(20/4.7)^{1/2}$. Accordingly, the same length defect damages 2.1 times more data in an HD-DVD than in a DVD.

Though HD-DVD seems to be more advantageous than a DVD due to HD-DVD's smaller spot size, HD-DVD's stabilization time required for restoring a reproduction signal (RF) is expected to be longer. Therefore, the effect of a spot size is thought to be similar in an HD-DVD and a DVD.

2) The effect of a small defect

Here, a small defect means a burst error which can be corrected by a PI, and is generated by a dust and the like. The length of the defect is equal to or less than 10.64 $\mu$m.

In table 1, when NA=0.85 and t=0.1 mm, the diameter of a beam spot incident upon the surface of an HD-DVD is 0.128 μm, which is 1/3.88 times that of a DVD, 0.496 μm. Therefore, HD-DVD's probability of error occurrence by a small defect becomes 3.88 times greater than that of an DVD.

In addition, since the line density of an HD-DVD is 2.1 times greater than that of a DVD, HD-DVD's probability of error occurrence is 8.148 times (3.88 x 2.1 = 8.148) greater than that of a DVD, for the same size defect. This means that when an HD-DVD uses the same modulation method as a DVD, error correction by a PI must be available for about 40.74 bytes (5 bytes x 8.148). Therefore, an HD-DVD requires a great number of PIs.

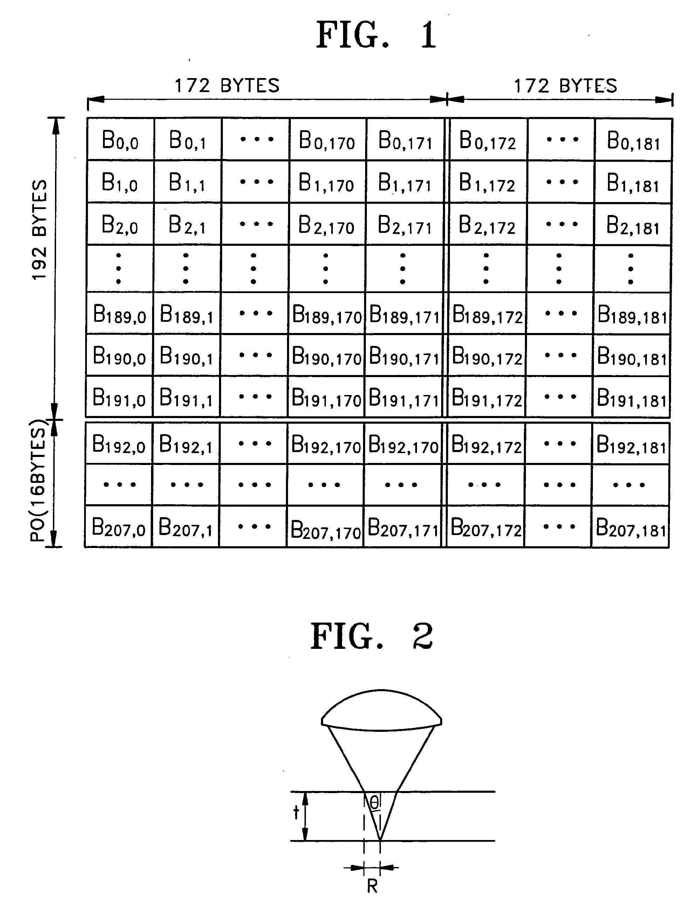

In the previous DVD error correction method shown in Figure 1, in order to raise the burst error correction capability, the number of data columns must be increased in the PI direction, while the number of data rows must be decreased in the PO direction.

However, when n, the number of data columns in the PI direction exceeds 256, a Galois Field operation, GF (28) cannot be performed.

That is, the previous error correction method in a DVD as shown in Figure 1 cannot be easily applied to HD-DVD.

With a view to solve or reduce the above problems, it is an aim of embodiments of the present invention to provide an error correction method appropriate for an HD-DVD.

It is another aim to provide a basic addressing structure appropriate for the HD-DVD.

According to a first aspect of the present invention, there is provided an error correction method adding inner parity and outer parity to an error correction block having a size of n bytes x m x o, the error correction method having the steps of obtaining a plurality of inner parity blocks (PI blocks) by segmenting the error correction block in the inner parity (PI) direction into x segments (here, x is an integer equal to or greater than 2); generating e-byte PI for each of the plurality of PI blocks generated by segmenting, and adding the PIs in the PI direction; and generating f-byte outer parity (PO) in the PO direction of the error correction block having PIs, and adding the POs in the PO direction.

It is preferable that a data frame, which forms an error correction block, is formed with two 2-KB user data blocks.

Also, it is preferable that the data form has Error Detection Codes (EDCs) for correcting errors in user data.

Preferably, the PIs are Reed-Solomon signs and satisfy (n/x) + e ≤256.

Preferably, n x m x o is 64K. 4. Preferably, n is 688 and m is 6. Preferably, x is 172 and e is 8. Preferably, f is 12.

The error correction method may further comprise a step of: interleaving the plurality of data groups and the plurality of PIs in the PI direction in the error correction blocks having PIs and POs.

Preferably, the plurality of data groups (DG0, DG1, ... Dgn/x) are reallocated by gathering bytes having the same order in the bytes included in each of the plurality of data groups.

Preferably, the reallocation is performed in the PI groups in the same row.

Preferably, the plurality of PIs (PI0, PI1, ..., PIn/x) are reallocated by gathering bytes having the same order in the bytes included in each of the plurality of PIs.

Preferably, the reallocation is performed in the PIs in the same row.

The error correction method may further comprise a step of: moving and allocating reallocated PIs between the reallocated PIs groups.

The error correction method may further comprise a step of: interleaving the POs in the PO direction.

Preferably, the PO direction interleaving further comprising the sub-steps of: obtaining an n x f byte bit stream by lining up the f-byte POs sequentially, and dividing the bit stream into each {(n x f)/m}; and moving and allocating the divided PO in the PO direction in each row.

Preferably, n x m is a basic address unit recorded on a disk, and a data frame is formed with a 4-byte ID, a 2-byte IED, an 18-byte RSV, two 2-KB user data blocks, and two 4-byte EDCs.

Preferably, f which is the number of PO direction parities, and x, which is the number of PI direction segments, are decided so that the result of multiplication of x with f can be divided by o, the number of data frames in one error correction block, without remainder, and a recording frame can be formed even when f is not equal to o.

For a better understanding of the invention, and to show how embodiments of the same may be carried into effect, reference will now be made, by way of example, to the accompanying diagrammatic drawings in which:

Figure 1 is the structure of an error correction code (ECC) block in a digital versatile disc (DVD) in the previous art;

Figure 2 illustrates the relationship between a beam spot and an object lens in an optical disc;

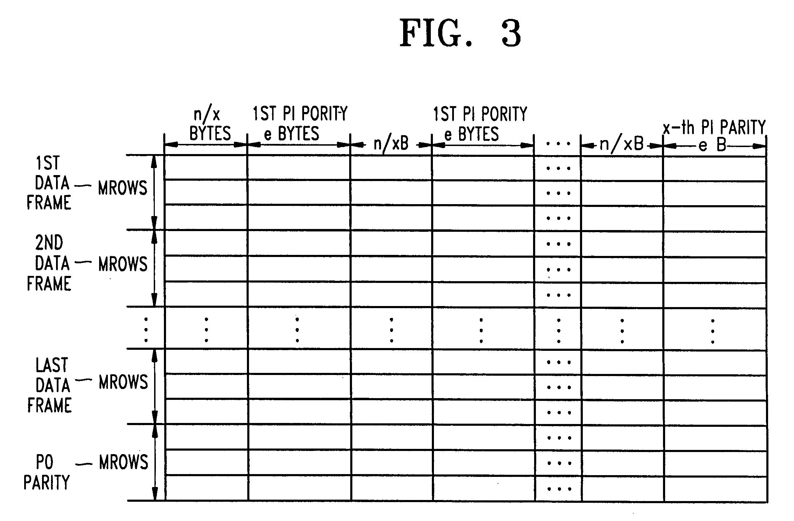

Figure 3 illustrates the relationships between an ECC block, an inner parity and an outer parity in the error correction method according to an embodiment of the present invention;

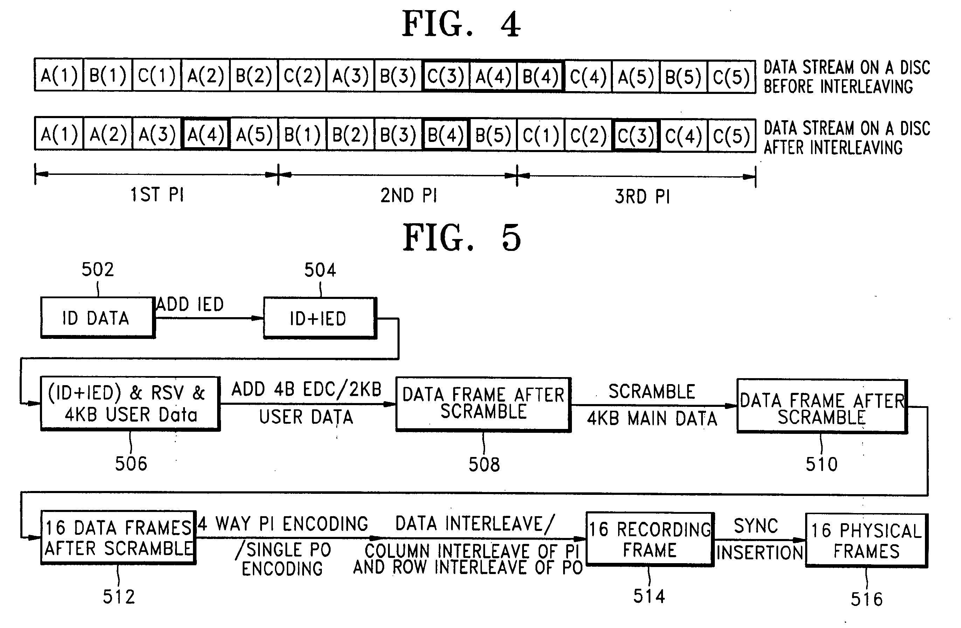

Figure 4 illustrates the effect by an interleave between inner parity (PI) blocks in the same row;

Figure 5 shows the process for performing an error correction method according to embodiments of the present invention;

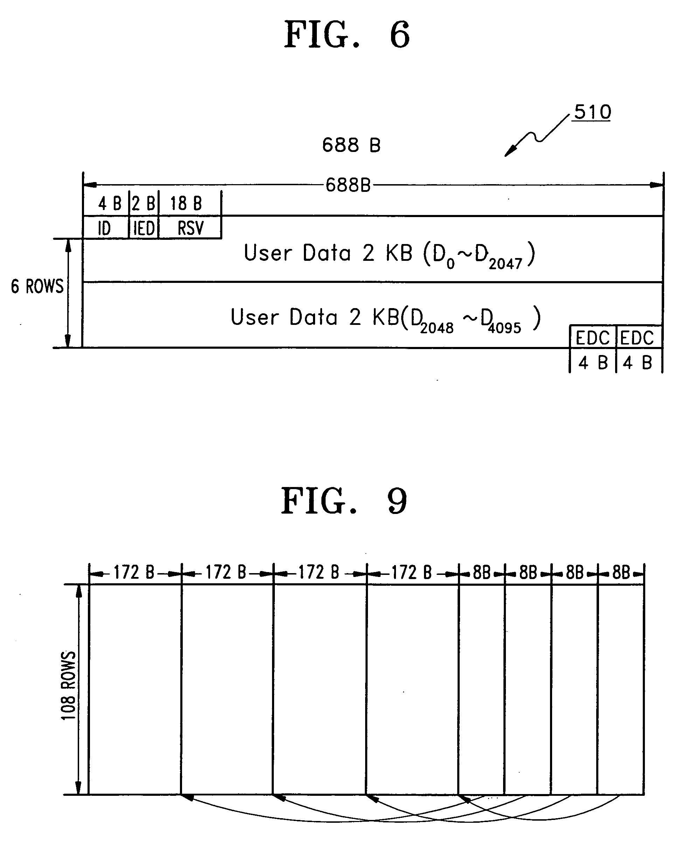

Figure 6 illustrates the structure of a data frame after it has been scrambled in the error correction method of Figure 5;

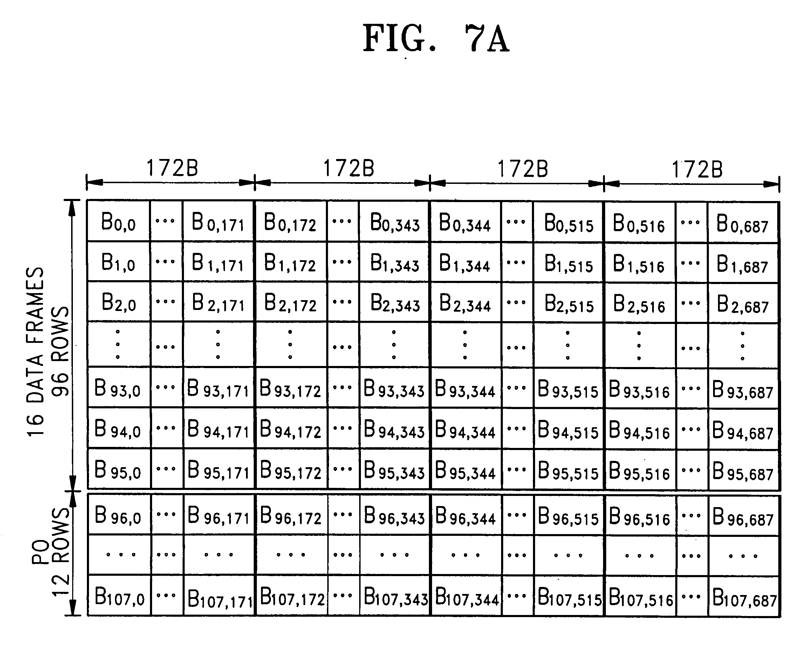

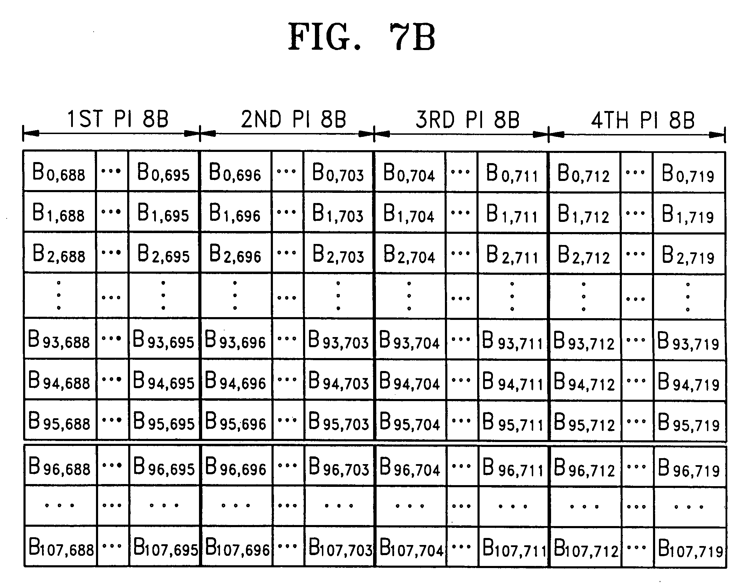

Figure 7 illustrates generation of inner parity and outer parity in an error correction block in the error correction method of Figure 5;

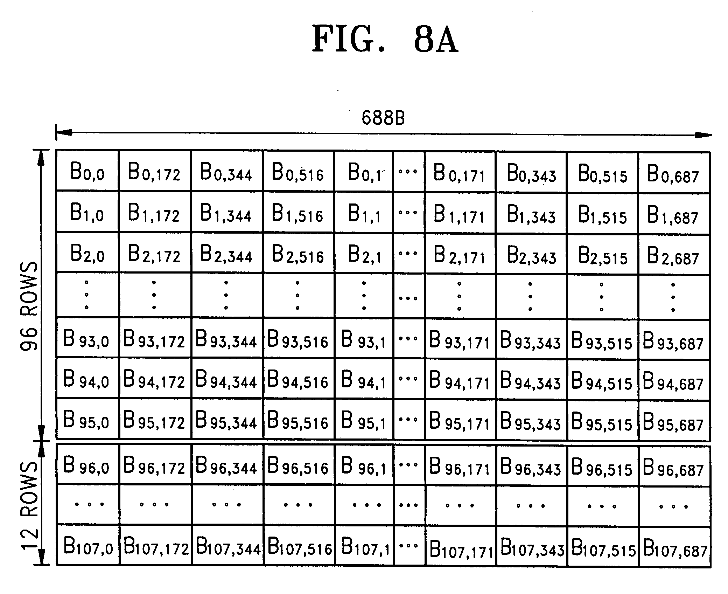

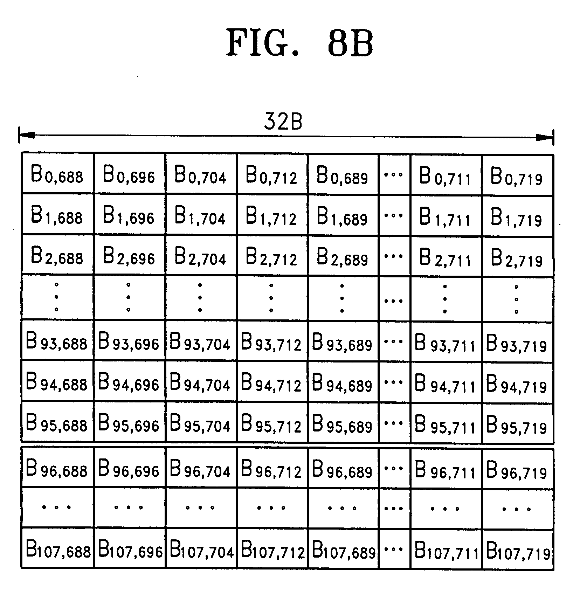

Figure 8 illustrates the result of interleaving to the inner parity direction in the error correction method of Figure 5;

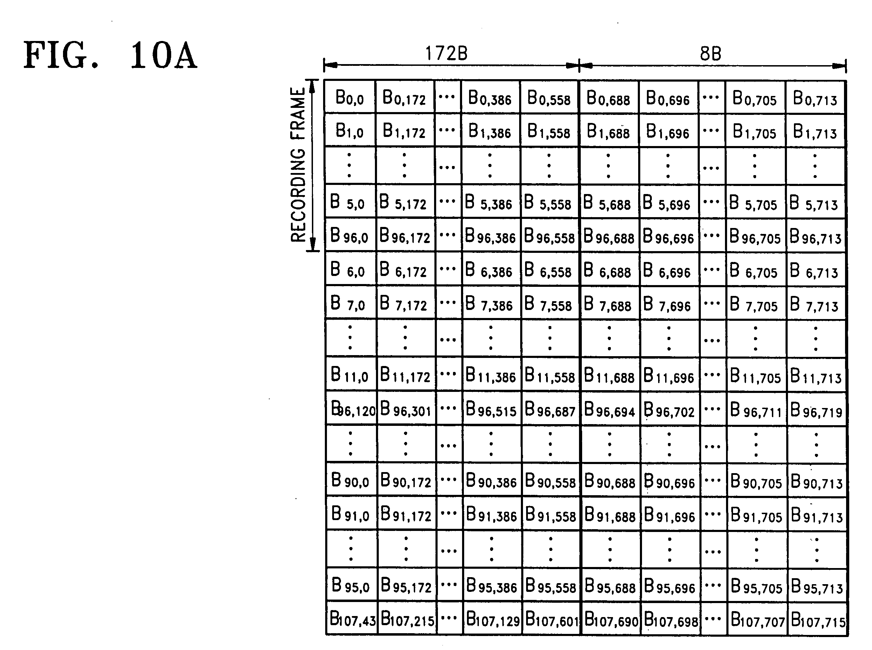

Figure 9 illustrates the result of interleaving the result shown in Figure 8 again in the inner parity direction; and

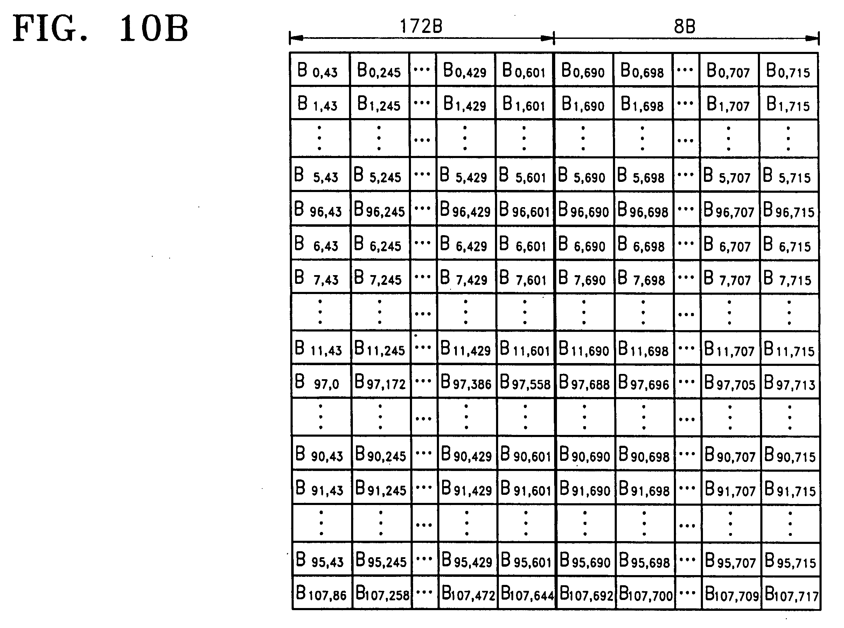

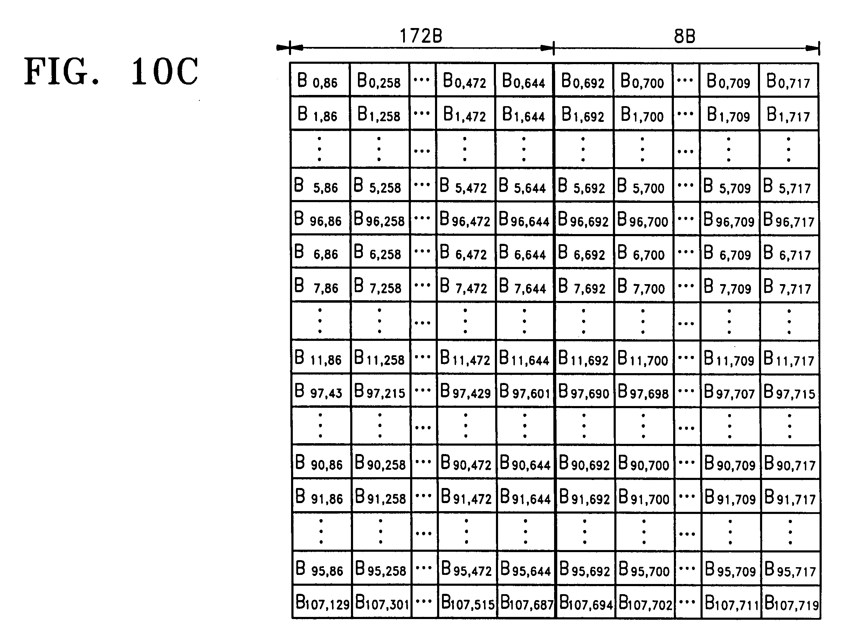

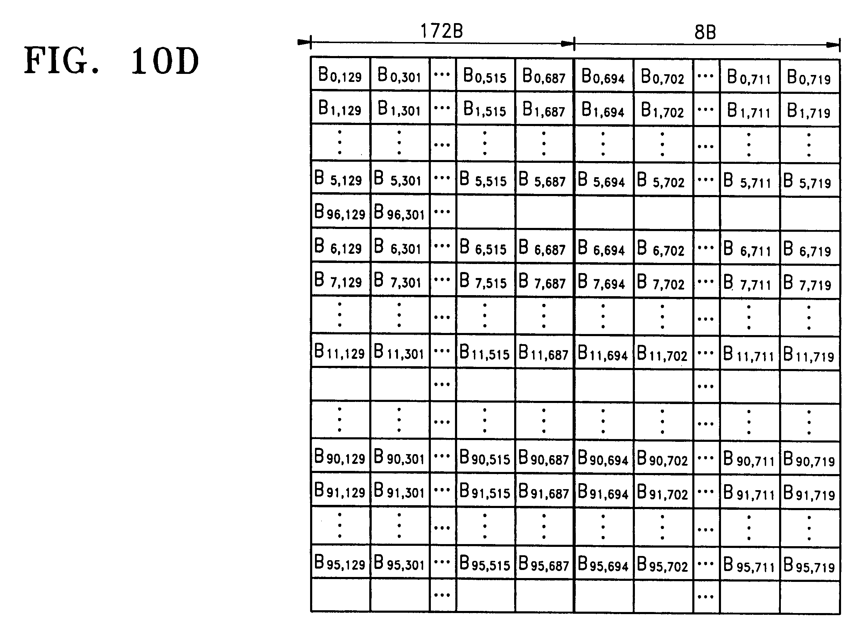

Figure 10 illustrates the result of interleaving in the outer parity direction in the error correction method in Figure 5.

Hereinafter, embodiments of the present invention will be described in detail with reference to the attached drawings. The present invention is not restricted to the following embodiments, and many variations are possible within the spirit and scope of the present invention. The embodiments of the present invention are provided in order to more completely explain the present invention to anyone skilled in the art.

Figure 3 illustrates the relationships between an error correction block, an inner parity (PI) and an outer parity (PO) in an error correction method according to the present invention. As a method for improving a burst error correction capability in using the same number of parities, it is preferable that the number of data columns is increased in the PI direction and the number of data rows is decreased in the PO direction.

However, since a Galois Field operation cannot be performed when n, the number of data columns in the PI direction exceeds 256, a multi-way PI error correction method is used in the error correction method according to the present invention.

That is, n, the number of data columns in a row is divided into segments with an appropriate size (x), and then, an e-byte PI is added to each segmented PI block. Here, the size n/x is determined to be an appropriate size for adding sink, and n, x, and e are determined so that n/x + e is less than or equal to 256.

If the number of data frames in the PO direction is 16, m (rows) x 16 + f (rows) is less than or equal to 256, and x, which is the number of PI direction segments, and f, which is the number of PO direction parities, are decided so that the result of multiplication of x with f is divided by o, the number of data frames, without remainder. The reason why decides so is because f can be not equal to o, the number of data frames unlike a DVD in which f is the same as o.

The error correction block shown in Figure 3 causes a problem when the block is recorded on a disc immediately after channel-modulation. That is, when a small defect occurs and equal to or more than e/2 bytes of data is damaged, correction by a PI becomes impossible. Therefore, after adding a flag indicating that all data in the corresponding PI block are not corrected, the data must be sent to an error correction process by a PO. When equal to or more than f data with a flag indicating that the data are not corrected by a PI are sent, the error correction is not possible by a PO either.

That is, in order to effectively correct small defects and sporadically occurring errors, interleaving is performed in the PI direction in x PI blocks.

Figure 4 illustrates the effect of interleaving PI blocks in the same row. As shown in Figure 4, even though a burst error occurs, the burst error changes into sporadic errors due to the interleaving between the PI blocks. Therefore, even when equal to or greater than e/2 bytes of data are damaged, the number of errors are reduced to equal to or less than e/2 in a PI block after interleaving, and error correction becomes possible.

There is another method in which e-byte parity is added to each x-th data in the same PI direction. In one method, interleaving is performed among PI blocks in different rows in order to increase the interleaving effect. In this method, however, delay from the time when error correction is completed to the time when data is output becomes longer. Therefore, it is preferable that the scope of interleaving is determined in consideration of the delay and the size of burst defects to be corrected.

Figure 5 shows the process for performing an error correction method according to embodiments of the present invention.

First, data for detection (IED) is added to address information (ID) 502.

Reserve space (RSV) for storing future scalability, user information, producer information, copyright protection, etc., and 4KB user data is added To "ID + IED" 504.

In "(ID + IED) & RSV & 4KB USER DATA" 506, 4 KB of user data is divided into 2KB, considering compatibility to existing a compact disc (CD) and a digital versatile disc (DVD), and then, an error detection code (EDC) for detecting an error is added. By doing so, one data frame is formed.

Next, in order to obtain data protection, channel modulation, and servo capacity, scrambling is performed on 1 data frame 508. For example, in order to properly perform scrambling of data on a 20 GB-level HD-DVD having 4KB data frames and a 64 KB basic unit for error correction, the length of the cycle of the random data generator in an HD-DVD having a 64 KB basic unit for error correction and a 4 KB user data in one data frame is designed to be 64 K, which is advantage in suppressing direct current (DC) component in servo operation and modulation.

Figure 6 illustrates the structure of a data frame it has been scrambled in the error correction method in Figure 5. Referring to the example in Figure 6, 1 data frame 510 is formed with a 4-byte ID, a 2-byte IED, an 18-byte RSV, two 2-KByte user data blocks, and two 4-byte EDCs. Here, 1 data frame is 688 bytes in the PI direction (column direction), and 6 rows in PO direction (row direction).

One error correction block 512 is formed by gathering 16 data frames shown in Figure 6, and a PI and a PO are added to the block.

Figure 7 illustrates the generation of inner parity and outer parity in an error correction block in the error correction method of Figure 5. Referring to Figure 7, in the present example, 16 data frames shown in Figure 6 are lined up and then, four PIs, each of which have 8 bytes in the PI direction, are added, and a PO, which has 12 byte to the PO direction, is added.

1) PO

PO is generated by using the Reed Solomon code RS(108, 96, 13).

That is, for data (B0,0 ~ Bi,j, i=0~95, j=0~687), B96, 0 ~ Bi,j are generated.

2) PI

PI is generated by using RS(180, 172, 9).

For data (Bi,0 ~ Bi,171, i=0~107), Bi,688 - Bi,695 (i=0 ~ 107) are generated; for data (Bi,172 - Bi,343, i=0~107), Bi, 696 ~ Bi,703 (i=0 ~ 107) are generated; for data (Bi, 344 ~ Bi,545, i=0~107), Bi, 704 ~ Bi,711 (i=0 ~ 107) are generated; and for data (Bi,546 - Bi,687, i=0~107), Bi,712 - Bi,719 (i=0 ~ 107) are generated.

The reason why parities are generated in 4 ways in the PI direction is because it is intended that one PI correction unit including parity does not exceed 256 so that a GF $(2^8)$ operation in a Galois Field can be performed. Also, it is intended that correction incapability flags can be added in four divided units so that erase correction in the PO correction process can be helped.

Also, it is because interleaving four PI blocks can improve PI correction capability. In the present invention, such an error correction method is referred to as Reed-Solomon multiple way PI or PO product code (RS-MWPC).

Next, a burst error in the PI direction is changed into sporadic errors, and in order to protect PI and PO, interleaving is performed in the PI direction.

Figure 8 illustrates the result of interleaving in the PI direction in the error correction method in Figure 5.

Referring to Figure 8, data in four PI blocks is reallocated one by one in a predetermined turn in data section and parity section.

Figure 9 illustrates the result of interleaving the result shown in Figure 8 again in the PI direction. PI divides each 8 bytes in the PI direction and performs interleaving. This is to prevent occurrence of burst errors in PIs.

When interleaving in PIs is completed, 12 rows including PO + PI parities from the 97th row to the 108th row are reorganized into 16 rows. The reason why 12 rows including PO + PI parities can be reorganized into 16 rows is that the result of multiplication of 4 (x), which is the number of PI direction segments, by 12 (f), which is the number of PO + PI parity rows, is 16 (o), the number of data frames. To achieve this, 720 bytes (688 + 32) in the first PO + PI parity row is multiplied by 3/4, and then, 540 bytes become the first new PO + PI parity row, and the remaining 720-540=180 bytes are passed to the second PO + PI parity row. The 180 bytes are added to 720 bytes that are in the second PO + PI parity row, and then the first 540 bytes in the result of the addition are changed into the second PO + PI parity row.

By doing so, the 12 rows are changed into a total of 16 rows of new PO + PI parity rows. By interleaving to the PO direction from the first row, all interleaving is finished and a total 16 recording frames are reorganized as shown in Figure 10. After inserting sink and performing channel modulation of these data, the form that can be actually recorded in optical disc is fully prepared.

Finally, sink is added to each data frame of error correction block 514 in which interleaving is finished. Error correction block in which sink is added is recorded in a disc.

As described above, the error correction method according to embodiments of the present invention maintains redundancy of parity code in the similar level to the existing DVDs, while enhancing error correction capability.

The reader's attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings), may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extend to any novel one, or any novel combination, of the features disclosed in this specification (including any accompanying claims, abstract and drawings), or to any novel one, or any novel combination, of the steps of any method or process so disclosed.

**Claims**

1. An error correction method directed to an error correction block encoded on an HD-DVD having data an inner parity direction, and an outer parity direction, the method comprising:

   segmenting the error correction block in the inner parity direction to form a plurality of inner parity segments;

   generating an e-byte inner parity for each of the plurality of inner parity segments; and

   adding the e-byte inner parities to form a plurality of inner parity blocks.

2. The error correction method of claim 1, further comprising:

   generating an f-byte outer parity; and

   adding the f-byte outer parities in the outer parity direction.

3. The error correction method of claim 2, further comprising adding the e-byte inner parities to the inner parity segments in the inner parity direction.

4. The error correction method of claim 3, further comprising interleaving the data after adding the e-byte parities to the inner parity segments.

5. The error correction method of claim 4, wherein the interleaving of the data comprises interleaving in the inner parity direction.

6. The error correction method of claim 5, wherein the interleaving of the data in the inner parity direction comprises interleaving the data within the inner parity blocks.

7. The error correction method of claim 6, wherein the interleaving of the data in the inner parity direction comprises interleaving four inner parity blocks one by one in a predetermined turn.

8. The error correction method of claim 6, wherein the interleaving of the data comprises interleaving the data in the outer parity direction.

9. The error correction method of claim 7, wherein the interleaving of the data comprises interleaving a quantity of the data in relation to the size of a burst error.

# FIG. 1

| | 172 BYTES | | | | 172 BYTES | | |
|---|---|---|---|---|---|---|---|
| $B_{0,0}$ | $B_{0,1}$ | $\cdots$ | $B_{0,170}$ | $B_{0,171}$ | $B_{0,172}$ | $\cdots$ | $B_{0,181}$ |
| $B_{1,0}$ | $B_{1,1}$ | $\cdots$ | $B_{1,170}$ | $B_{1,171}$ | $B_{1,172}$ | $\cdots$ | $B_{1,181}$ |
| $B_{2,0}$ | $B_{2,1}$ | $\cdots$ | $B_{2,170}$ | $B_{2,171}$ | $B_{2,172}$ | $\cdots$ | $B_{2,181}$ |
| $\vdots$ | $\vdots$ | $\vdots$ | $\vdots$ | $\vdots$ | $\vdots$ | $\vdots$ | $\vdots$ |
| $B_{189,0}$ | $B_{189,1}$ | $\cdots$ | $B_{189,170}$ | $B_{189,171}$ | $B_{189,172}$ | $\cdots$ | $B_{189,181}$ |
| $B_{190,0}$ | $B_{190,1}$ | $\cdots$ | $B_{190,170}$ | $B_{190,171}$ | $B_{190,172}$ | $\cdots$ | $B_{190,181}$ |
| $B_{191,0}$ | $B_{191,1}$ | $\cdots$ | $B_{191,170}$ | $B_{191,171}$ | $B_{191,172}$ | $\cdots$ | $B_{191,181}$ |
| $B_{192,0}$ | $B_{192,1}$ | $\cdots$ | $B_{192,170}$ | $B_{192,170}$ | $B_{192,172}$ | $\cdots$ | $B_{192,181}$ |
| $\cdots$ | $\cdots$ | $\cdots$ | $\cdots$ | $\cdots$ | $\cdots$ | $\cdots$ | $\cdots$ |
| $B_{207,0}$ | $B_{207,1}$ | $\cdots$ | $B_{207,170}$ | $B_{207,171}$ | $B_{207,172}$ | $\cdots$ | $B_{207,181}$ |

(Vertical labels: 192 BYTES, PO(16BYTES))

# FIG. 2

# FIG. 3

EP 1 580 899 A1

EP 1 580 899 A1

# FIG. 4

| A(1) | B(1) | C(1) | A(2) | B(2) | C(2) | A(3) | B(3) | C(3) | A(4) | B(4) | C(4) | A(5) | B(5) | C(5) | DATA STREAM ON A DISC BEFORE INTERLEAVING |

| A(1) | A(2) | A(3) | A(4) | A(5) | B(1) | B(2) | B(3) | B(4) | B(5) | C(1) | C(2) | C(3) | C(4) | C(5) | DATA STREAM ON A DISC AFTER INTERLEAVING |

1ST PI      2ND PI      3RD PI

# FIG. 5

502
**ID DATA** → ADD IED → 504 **ID+IED**

506 **(ID+IED) & RSV & 4KB USER Data** → ADD 4B EDC/2KB USER DATA → 508 **DATA FRAME AFTER SCRAMBLE** → SCRAMBLE 4KB MAIN DATA → 510 **DATA FRAME AFTER SCRAMBLE**

512 **16 DATA FRAMES AFTER SCRAMBLE** → 4 WAY PI ENCODING /SINGLE PO ENCODING → DATA INTERLEAVE/ COLUMN INTERLEAVE OF PI AND ROW INTERLEAVE OF PO → 514 **16 RECORDING FRAME** → SYNC INSERTION → 516 **16 PHYSICAL FRAMES**

# FIG. 6

510

688 B

|←─────────────────────────── 688B ───────────────────────────→|

| 4 B | 2 B | 18 B | |
|:---:|:---:|:---:|---|
| ID | IED | RSV | |

6 ROWS

User Data 2 KB ($D_0 \sim D_{2047}$)

User Data 2 KB($D_{2048} \sim D_{4095}$)

| EDC | EDC |
|:---:|:---:|
| 4 B | 4 B |

# FIG. 9

|←─ 172 B ─→|←─ 172 B ─→|←─ 172 B ─→|←─ 172 B ─→|← 8B →|← 8B →|← 8B →|← 8B →|

108 ROWS

# FIG. 7A

|  | 172B |  | 172B |  | 172B |  | 172B |  | 172B |  |  |
|---|---|---|---|---|---|---|---|---|---|---|---|
| $B_{0,0}$ | ⋯ | $B_{0,171}$ | $B_{0,172}$ | ⋯ | $B_{0,343}$ | $B_{0,344}$ | ⋯ | $B_{0,515}$ | $B_{0,516}$ | ⋯ | $B_{0,687}$ |
| $B_{1,0}$ | ⋯ | $B_{1,171}$ | $B_{1,172}$ | ⋯ | $B_{1,343}$ | $B_{1,344}$ | ⋯ | $B_{1,515}$ | $B_{1,516}$ | ⋯ | $B_{1,687}$ |
| $B_{2,0}$ | ⋯ | $B_{2,171}$ | $B_{2,172}$ | ⋯ | $B_{2,343}$ | $B_{2,344}$ | ⋯ | $B_{2,515}$ | $B_{2,516}$ | ⋯ | $B_{2,687}$ |
| ⋮ | ⋮ | ⋮ | ⋯ | ⋮ | ⋯ | ⋯ | ⋮ | ⋯ | ⋯ | ⋮ | ⋯ |
| $B_{93,0}$ | ⋯ | $B_{93,171}$ | $B_{93,172}$ | ⋯ | $B_{93,343}$ | $B_{93,344}$ | ⋯ | $B_{93,515}$ | $B_{93,516}$ | ⋯ | $B_{93,687}$ |
| $B_{94,0}$ | ⋯ | $B_{94,171}$ | $B_{94,172}$ | ⋯ | $B_{94,343}$ | $B_{94,344}$ | ⋯ | $B_{94,515}$ | $B_{94,516}$ | ⋯ | $B_{94,687}$ |
| $B_{95,0}$ | ⋯ | $B_{95,171}$ | $B_{95,172}$ | ⋯ | $B_{95,343}$ | $B_{95,344}$ | ⋯ | $B_{95,515}$ | $B_{95,516}$ | ⋯ | $B_{95,687}$ |
| $B_{96,0}$ | ⋯ | $B_{96,171}$ | $B_{96,172}$ | ⋯ | $B_{96,343}$ | $B_{96,344}$ | ⋯ | $B_{96,515}$ | $B_{96,516}$ | ⋯ | $B_{96,687}$ |
| ⋮ | ⋮ | ⋮ | ⋮ | ⋮ | ⋮ | ⋮ | ⋮ | ⋮ | ⋮ | ⋮ | ⋮ |
| $B_{107,0}$ | ⋯ | $B_{107,171}$ | $B_{107,172}$ | ⋯ | $B_{107,343}$ | $B_{107,344}$ | ⋯ | $B_{107,515}$ | $B_{107,516}$ | ⋯ | $B_{107,687}$ |

16 DATA FRAMES 96 ROWS

P0 12 ROWS

FIG. 7B

| 1ST PI 8B | | | 2ND PI 8B | | | 3RD PI 8B | | | 4TH PI 8B | | |
|---|---|---|---|---|---|---|---|---|---|---|---|
| $B_{0,688}$ | $\cdots$ | $B_{0,695}$ | $B_{0,696}$ | $\cdots$ | $B_{0,703}$ | $B_{0,704}$ | $\cdots$ | $B_{0,711}$ | $B_{0,712}$ | $\cdots$ | $B_{0,719}$ |
| $B_{1,688}$ | $\cdots$ | $B_{1,695}$ | $B_{1,696}$ | $\cdots$ | $B_{1,703}$ | $B_{1,704}$ | $\cdots$ | $B_{1,711}$ | $B_{1,712}$ | $\cdots$ | $B_{1,719}$ |
| $B_{2,688}$ | $\cdots$ | $B_{2,695}$ | $B_{2,696}$ | $\cdots$ | $B_{2,703}$ | $B_{2,704}$ | $\cdots$ | $B_{2,711}$ | $B_{2,712}$ | $\cdots$ | $B_{2,719}$ |
| $\vdots$ | $\cdots$ | $\vdots$ | $\vdots$ | $\cdots$ | $\vdots$ | $\vdots$ | $\cdots$ | $\vdots$ | $\vdots$ | $\cdots$ | $\vdots$ |
| $B_{93,688}$ | $\cdots$ | $B_{93,695}$ | $B_{93,696}$ | $\cdots$ | $B_{93,703}$ | $B_{93,704}$ | $\cdots$ | $B_{93,711}$ | $B_{93,712}$ | $\cdots$ | $B_{93,719}$ |
| $B_{94,688}$ | $\cdots$ | $B_{94,695}$ | $B_{94,696}$ | $\cdots$ | $B_{94,703}$ | $B_{94,704}$ | $\cdots$ | $B_{94,711}$ | $B_{94,712}$ | $\cdots$ | $B_{94,719}$ |
| $B_{95,688}$ | $\cdots$ | $B_{95,695}$ | $B_{95,696}$ | $\cdots$ | $B_{95,703}$ | $B_{95,704}$ | $\cdots$ | $B_{95,711}$ | $B_{95,712}$ | $\cdots$ | $B_{95,719}$ |
| $B_{96,688}$ | $\cdots$ | $B_{96,695}$ | $B_{96,696}$ | $\cdots$ | $B_{96,703}$ | $B_{96,704}$ | $\cdots$ | $B_{96,711}$ | $B_{96,712}$ | $\cdots$ | $B_{96,719}$ |
| $\cdots$ | $\cdots$ | $\cdots$ | $\cdots$ | $\cdots$ | $\cdots$ | $\cdots$ | $\cdots$ | $\cdots$ | $\cdots$ | $\cdots$ | $\cdots$ |
| $B_{107,688}$ | $\cdots$ | $B_{107,695}$ | $B_{107,696}$ | $\cdots$ | $B_{107,703}$ | $B_{107,704}$ | $\cdots$ | $B_{107,711}$ | $B_{107,712}$ | $\cdots$ | $B_{107,719}$ |

EP 1 580 899 A1

## FIG. 8A

688B

| | $B_{i,0}$ | $B_{i,172}$ | $B_{i,344}$ | $B_{i,516}$ | $B_{i,1}$ | $\cdots$ | $B_{i,171}$ | $B_{i,343}$ | $B_{i,515}$ | $B_{i,687}$ |
|---|---|---|---|---|---|---|---|---|---|---|
| | $B_{0,0}$ | $B_{0,172}$ | $B_{0,344}$ | $B_{0,516}$ | $B_{0,1}$ | $\cdots$ | $B_{0,171}$ | $B_{0,343}$ | $B_{0,515}$ | $B_{0,687}$ |
| | $B_{1,0}$ | $B_{1,172}$ | $B_{1,344}$ | $B_{1,516}$ | $B_{1,1}$ | $\cdots$ | $B_{1,171}$ | $B_{1,343}$ | $B_{1,515}$ | $B_{1,687}$ |
| | $B_{2,0}$ | $B_{2,172}$ | $B_{2,344}$ | $B_{2,516}$ | $B_{2,1}$ | $\cdots$ | $B_{2,171}$ | $B_{2,343}$ | $B_{2,515}$ | $B_{2,687}$ |
| 96 ROWS | $\cdots$ | $\cdots$ | $\cdots$ | $\cdots$ | $\cdots$ | $\vdots$ | $\cdots$ | $\cdots$ | $\cdots$ | $\cdots$ |
| | $B_{93,0}$ | $B_{93,172}$ | $B_{93,344}$ | $B_{93,516}$ | $B_{93,1}$ | $\cdots$ | $B_{93,171}$ | $B_{93,343}$ | $B_{93,515}$ | $B_{93,687}$ |
| | $B_{94,0}$ | $B_{94,172}$ | $B_{94,344}$ | $B_{94,516}$ | $B_{94,1}$ | $\cdots$ | $B_{94,171}$ | $B_{94,343}$ | $B_{94,515}$ | $B_{94,687}$ |
| | $B_{95,0}$ | $B_{95,172}$ | $B_{95,344}$ | $B_{95,516}$ | $B_{95,1}$ | $\cdots$ | $B_{95,171}$ | $B_{95,343}$ | $B_{95,515}$ | $B_{95,687}$ |
| | $B_{96,0}$ | $B_{96,172}$ | $B_{96,344}$ | $B_{96,516}$ | $B_{96,1}$ | $\cdots$ | $B_{96,171}$ | $B_{96,343}$ | $B_{96,515}$ | $B_{96,687}$ |
| 12 ROWS | $\vdots$ | $\vdots$ | $\vdots$ | $\vdots$ | $\vdots$ | $\vdots$ | $\vdots$ | $\vdots$ | $\vdots$ | $\vdots$ |
| | $B_{107,0}$ | $B_{107,172}$ | $B_{107,344}$ | $B_{107,516}$ | $B_{107,1}$ | $\cdots$ | $B_{107,171}$ | $B_{107,343}$ | $B_{107,515}$ | $B_{107,687}$ |

13

EP 1 580 899 A1

# FIG. 8B

32B

| $B_{0,688}$ | $B_{0,696}$ | $B_{0,704}$ | $B_{0,712}$ | $B_{0,689}$ | ··· | $B_{0,711}$ | $B_{0,719}$ |
|---|---|---|---|---|---|---|---|
| $B_{1,688}$ | $B_{1,696}$ | $B_{1,704}$ | $B_{1,712}$ | $B_{1,689}$ | ··· | $B_{1,711}$ | $B_{1,719}$ |
| $B_{2,688}$ | $B_{2,696}$ | $B_{2,704}$ | $B_{2,712}$ | $B_{2,689}$ | ··· | $B_{2,711}$ | $B_{2,719}$ |
| ⋮ | ⋮ | ⋮ | ⋮ | ⋮ | ··· | ⋮ | ⋮ |
| $B_{93,688}$ | $B_{93,696}$ | $B_{93,704}$ | $B_{93,712}$ | $B_{93,689}$ | ··· | $B_{93,711}$ | $B_{93,719}$ |
| $B_{94,688}$ | $B_{94,696}$ | $B_{94,704}$ | $B_{94,712}$ | $B_{94,689}$ | ··· | $B_{94,711}$ | $B_{94,719}$ |
| $B_{95,688}$ | $B_{95,696}$ | $B_{95,704}$ | $B_{95,712}$ | $B_{95,689}$ | ··· | $B_{95,711}$ | $B_{95,719}$ |
| $B_{96,688}$ | $B_{96,696}$ | $B_{96,704}$ | $B_{96,712}$ | $B_{96,689}$ | ··· | $B_{96,711}$ | $B_{96,719}$ |
| ··· | ··· | ··· | ··· | ··· | ··· | ··· | ··· |
| $B_{107,688}$ | $B_{107,696}$ | $B_{107,704}$ | $B_{107,712}$ | $B_{107,689}$ | ··· | $B_{107,711}$ | $B_{107,719}$ |

## FIG. 10A

| RECORDING FRAME | 172B | | | | | 8B | | | |
|---|---|---|---|---|---|---|---|---|---|
| | $B_{0,0}$ | $B_{0,172}$ | $\cdots$ | $B_{0,386}$ | $B_{0,558}$ | $B_{0,688}$ | $B_{0,696}$ | $\cdots$ | $B_{0,705}$ | $B_{0,713}$ |
| | $B_{1,0}$ | $B_{1,172}$ | $\cdots$ | $B_{1,386}$ | $B_{1,558}$ | $B_{1,688}$ | $B_{1,696}$ | $\cdots$ | $B_{1,705}$ | $B_{1,713}$ |
| | $\vdots$ | $\vdots$ | $\cdots$ | $\vdots$ | $\vdots$ | $\vdots$ | $\vdots$ | $\cdots$ | $\vdots$ | $\vdots$ |
| | $B_{5,0}$ | $B_{5,172}$ | $\cdots$ | $B_{5,386}$ | $B_{5,558}$ | $B_{5,688}$ | $B_{5,696}$ | $\cdots$ | $B_{5,705}$ | $B_{5,713}$ |
| | $B_{96,0}$ | $B_{96,172}$ | $\cdots$ | $B_{96,386}$ | $B_{96,558}$ | $B_{96,688}$ | $B_{96,696}$ | $\cdots$ | $B_{96,705}$ | $B_{96,713}$ |
| | $B_{6,0}$ | $B_{6,172}$ | $\cdots$ | $B_{6,386}$ | $B_{6,558}$ | $B_{6,688}$ | $B_{6,696}$ | $\cdots$ | $B_{6,705}$ | $B_{6,713}$ |
| | $B_{7,0}$ | $B_{7,172}$ | $\cdots$ | $B_{7,386}$ | $B_{7,558}$ | $B_{7,688}$ | $B_{7,696}$ | $\cdots$ | $B_{7,705}$ | $B_{7,713}$ |
| | $\vdots$ | $\vdots$ | $\cdots$ | $\vdots$ | $\vdots$ | $\vdots$ | $\vdots$ | $\cdots$ | $\vdots$ | $\vdots$ |
| | $B_{11,0}$ | $B_{11,172}$ | $\cdots$ | $B_{11,386}$ | $B_{11,558}$ | $B_{11,688}$ | $B_{11,696}$ | $\cdots$ | $B_{11,705}$ | $B_{11,713}$ |
| | $B_{96,120}$ | $B_{96,301}$ | $\cdots$ | $B_{96,515}$ | $B_{96,687}$ | $B_{96,694}$ | $B_{96,702}$ | $\cdots$ | $B_{96,711}$ | $B_{96,719}$ |
| | $\vdots$ | $\vdots$ | $\cdots$ | $\vdots$ | $\vdots$ | $\vdots$ | $\vdots$ | $\cdots$ | $\vdots$ | $\vdots$ |
| | $B_{90,0}$ | $B_{90,172}$ | $\cdots$ | $B_{90,386}$ | $B_{90,558}$ | $B_{90,688}$ | $B_{90,696}$ | $\cdots$ | $B_{90,705}$ | $B_{90,713}$ |
| | $B_{91,0}$ | $B_{91,172}$ | $\cdots$ | $B_{91,386}$ | $B_{91,558}$ | $B_{91,688}$ | $B_{91,696}$ | $\cdots$ | $B_{91,705}$ | $B_{91,713}$ |
| | $\vdots$ | $\vdots$ | $\cdots$ | $\vdots$ | $\vdots$ | $\vdots$ | $\vdots$ | $\cdots$ | $\vdots$ | $\vdots$ |
| | $B_{95,0}$ | $B_{95,172}$ | $\cdots$ | $B_{95,386}$ | $B_{95,558}$ | $B_{95,688}$ | $B_{95,696}$ | $\cdots$ | $B_{95,705}$ | $B_{95,713}$ |
| | $B_{107,43}$ | $B_{107,215}$ | $\cdots$ | $B_{107,129}$ | $B_{107,601}$ | $B_{107,690}$ | $B_{107,698}$ | $\cdots$ | $B_{107,707}$ | $B_{107,715}$ |

EP 1 580 899 A1

# FIG. 10B

EP 1 580 899 A1

| 172B | | | | 8B | | | |
|---|---|---|---|---|---|---|---|
| $B_{0,43}$ | $B_{0,245}$ | ··· $B_{0,429}$ | $B_{0,601}$ | $B_{0,690}$ | $B_{0,698}$ | ··· $B_{0,707}$ | $B_{0,715}$ |
| $B_{1,43}$ | $B_{1,245}$ | ··· $B_{1,429}$ | $B_{1,601}$ | $B_{1,690}$ | $B_{1,698}$ | ··· $B_{1,707}$ | $B_{1,715}$ |
| ⋮ | ⋮ | ··· ⋮ | ⋮ | ⋮ | ⋮ | ··· ⋮ | ⋮ |
| $B_{5,43}$ | $B_{5,245}$ | ··· $B_{5,429}$ | $B_{5,601}$ | $B_{5,690}$ | $B_{5,698}$ | ··· $B_{5,707}$ | $B_{5,715}$ |
| $B_{96,43}$ | $B_{96,245}$ | ··· $B_{96,429}$ | $B_{96,601}$ | $B_{96,690}$ | $B_{96,698}$ | ··· $B_{96,707}$ | $B_{96,715}$ |
| $B_{6,43}$ | $B_{6,245}$ | ··· $B_{6,429}$ | $B_{6,601}$ | $B_{6,690}$ | $B_{6,698}$ | ··· $B_{6,707}$ | $B_{6,715}$ |
| $B_{7,43}$ | $B_{7,245}$ | ··· $B_{7,429}$ | $B_{7,601}$ | $B_{7,690}$ | $B_{7,698}$ | ··· $B_{7,707}$ | $B_{7,715}$ |
| ⋮ | ⋮ | ··· ⋮ | ⋮ | ⋮ | ⋮ | ··· ⋮ | ⋮ |
| $B_{11,43}$ | $B_{11,245}$ | ··· $B_{11,429}$ | $B_{11,601}$ | $B_{11,690}$ | $B_{11,698}$ | ··· $B_{11,707}$ | $B_{11,715}$ |
| $B_{97,0}$ | $B_{97,172}$ | ··· $B_{97,386}$ | $B_{97,558}$ | $B_{97,688}$ | $B_{97,696}$ | ··· $B_{97,705}$ | $B_{97,713}$ |
| ⋮ | ⋮ | ··· ⋮ | ⋮ | ⋮ | ⋮ | ··· ⋮ | ⋮ |
| $B_{90,43}$ | $B_{90,245}$ | ··· $B_{90,429}$ | $B_{90,601}$ | $B_{90,690}$ | $B_{90,698}$ | ··· $B_{90,707}$ | $B_{90,715}$ |
| $B_{91,43}$ | $B_{91,245}$ | ··· $B_{91,429}$ | $B_{91,601}$ | $B_{91,690}$ | $B_{91,698}$ | ··· $B_{91,707}$ | $B_{91,715}$ |
| ⋮ | ⋮ | ··· ⋮ | ⋮ | ⋮ | ⋮ | ··· ⋮ | ⋮ |
| $B_{95,43}$ | $B_{95,245}$ | ··· $B_{95,429}$ | $B_{95,601}$ | $B_{95,690}$ | $B_{95,698}$ | ··· $B_{95,707}$ | $B_{95,715}$ |
| $B_{107,86}$ | $B_{107,258}$ | ··· $B_{107,472}$ | $B_{107,644}$ | $B_{107,692}$ | $B_{107,700}$ | ··· $B_{107,709}$ | $B_{107,717}$ |

# FIG. 10C

| | | 172B | | | | | 8B | | |
|---|---|---|---|---|---|---|---|---|---|
| B 0,86 | B 0,258 | ... | B 0,472 | B 0,644 | B 0,692 | B 0,700 | ... | B 0,709 | B 0,717 |
| B 1,86 | B 1,258 | ... | B 1,472 | B 1,644 | B 1,692 | B 1,700 | ... | B 1,709 | B 1,717 |
| ... | ... | ⋮ | ... | ... | ... | ... | ⋮ | ... | ... |
| B 5,86 | B 5,258 | ... | B 5,472 | B 5,644 | B 5,692 | B 5,700 | ... | B 5,709 | B 5,717 |
| B 96,86 | B 96,258 | ... | B 96,472 | B 96,644 | B 96,692 | B 96,700 | ... | B 96,709 | B 96,717 |
| B 6,86 | B 6,258 | ... | B 6,472 | B 6,644 | B 6,692 | B 6,700 | ... | B 6,709 | B 6,717 |
| B 7,86 | B 7,258 | ... | B 7,472 | B 7,644 | B 7,692 | B 7,700 | ... | B 7,709 | B 7,717 |
| ... | ... | ⋮ | ... | ... | ... | ... | ⋮ | ... | ... |
| B 11,86 | B 11,258 | ... | B 11,472 | B 11,644 | B 11,692 | B 11,700 | ... | B 11,709 | B 11,717 |
| B 97,43 | B 97,215 | ... | B 97,429 | B 97,601 | B 97,690 | B 97,698 | ... | B 97,707 | B 97,715 |
| ... | ... | ⋮ | ... | ... | ... | ... | ⋮ | ... | ... |
| B 90,86 | B 90,258 | ... | B 90,472 | B 90,644 | B 90,692 | B 90,700 | ... | B 90,709 | B 90,717 |
| B 91,86 | B 91,258 | ... | B 91,472 | B 91,644 | B 91,692 | B 91,700 | ... | B 91,709 | B 91,717 |
| ... | ... | ⋮ | ... | ... | ... | ... | ⋮ | ... | ... |
| B 95,86 | B 95,258 | ... | B 95,472 | B 95,644 | B 95,692 | B 95,700 | ... | B 95,709 | B 95,717 |
| B107,129 | B107,301 | ... | B107,515 | B107,687 | B107,694 | B107,702 | ... | B107,711 | B107,719 |

17

# FIG. 10D

| | 172B | | | | 8B | | | |
|---|---|---|---|---|---|---|---|---|
| $B_{0,129}$ | $B_{0,301}$ | $\cdots$ | $B_{0,515}$ | $B_{0,687}$ | $B_{0,694}$ | $B_{0,702}$ | $\cdots$ $B_{0,711}$ | $B_{0,719}$ |
| $B_{1,129}$ | $B_{1,301}$ | $\cdots$ | $B_{1,515}$ | $B_{1,687}$ | $B_{1,694}$ | $B_{1,702}$ | $\cdots$ $B_{1,711}$ | $B_{1,719}$ |
| $\vdots$ | $\vdots$ | $\cdots$ | $\vdots$ | $\vdots$ | $\vdots$ | $\vdots$ | $\cdots$ $\vdots$ | $\vdots$ |
| $B_{5,129}$ | $B_{5,301}$ | $\cdots$ | $B_{5,515}$ | $B_{5,687}$ | $B_{5,694}$ | $B_{5,702}$ | $\cdots$ $B_{5,711}$ | $B_{5,719}$ |
| $B_{96,129}$ | $B_{96,301}$ | $\cdots$ | | | | | | |
| $B_{6,129}$ | $B_{6,301}$ | $\cdots$ | $B_{6,515}$ | $B_{6,687}$ | $B_{6,694}$ | $B_{6,702}$ | $\cdots$ $B_{6,711}$ | $B_{6,719}$ |
| $B_{7,129}$ | $B_{7,301}$ | $\cdots$ | $B_{7,515}$ | $B_{7,687}$ | $B_{7,694}$ | $B_{7,702}$ | $\cdots$ $B_{7,711}$ | $B_{7,719}$ |
| $\vdots$ | $\vdots$ | $\cdots$ | $\vdots$ | $\vdots$ | $\vdots$ | $\vdots$ | $\cdots$ $\vdots$ | $\vdots$ |
| $B_{11,129}$ | $B_{11,301}$ | $\cdots$ | $B_{11,515}$ | $B_{11,687}$ | $B_{11,694}$ | $B_{11,702}$ | $\cdots$ $B_{11,711}$ | $B_{11,719}$ |
| | | $\cdots$ | | | | | $\cdots$ | |
| $\vdots$ | $\vdots$ | $\cdots$ | $\vdots$ | $\vdots$ | $\vdots$ | $\vdots$ | $\cdots$ $\vdots$ | $\vdots$ |
| $B_{90,129}$ | $B_{90,301}$ | $\cdots$ | $B_{90,515}$ | $B_{90,687}$ | $B_{90,694}$ | $B_{90,702}$ | $\cdots$ $B_{90,711}$ | $B_{90,719}$ |
| $B_{91,129}$ | $B_{91,301}$ | $\cdots$ | $B_{91,515}$ | $B_{91,687}$ | $B_{91,694}$ | $B_{91,702}$ | $\cdots$ $B_{91,711}$ | $B_{91,719}$ |
| $\vdots$ | $\vdots$ | $\cdots$ | $\vdots$ | $\vdots$ | $\vdots$ | $\vdots$ | $\cdots$ $\vdots$ | $\vdots$ |
| $B_{95,129}$ | $B_{95,301}$ | $\cdots$ | $B_{95,515}$ | $B_{95,687}$ | $B_{95,694}$ | $B_{95,702}$ | $\cdots$ $B_{95,711}$ | $B_{95,719}$ |
| | | $\cdots$ | | | | | $\cdots$ | |

EP 1 580 899 A1

**European Patent Office**

## EUROPEAN SEARCH REPORT

Application Number

EP 05 00 6686

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | PATENT ABSTRACTS OF JAPAN vol. 1999, no. 03, 31 March 1999 (1999-03-31) & JP 10 334607 A (MATSUSHITA ELECTRIC IND CO LTD), 18 December 1998 (1998-12-18) * abstract * | 1-3 | H03M13/15 G11B20/18 H03M13/29 |
| X | & US 6 079 043 A (YOSHIURA ET AL) 20 June 2000 (2000-06-20) * the whole document * | 1-3 | |
| Y | | 1-9 | |
| Y | ----- LINDER H ET AL: "A forward error correction based multicast transport protocol for multimedia applications in satellite environments" PERFORMANCE, COMPUTING, AND COMMUNICATIONS CONFERENCE, 1997. IPCCC 1997., IEEE INTERNATIONAL PHOENIX, TEMPE, AZ, USA 5-7 FEB. 1997, NEW YORK, NY, USA,IEEE, US, 5 February 1997 (1997-02-05), pages 419-425, XP010217019 ISBN: 0-7803-3873-1 * the whole document * | 4-9 | |
| Y | ----- ECMA: STANDARDIZING INFORMATION AND COMMUNICATION SYSTEMS: "Standard ECMA-272, 2nd edition: 120 mm DVD Rewritable Disk (DVD-RAM)" STANDARD ECMA-272, XX, XX, no. 272, June 1999 (1999-06), pages 1-99, XP002186767 * page 14 - page 23 * ----- | 1-9 | TECHNICAL FIELDS SEARCHED (Int.Cl.7) H03M G11B |

The present search report has been drawn up for all claims

| Place of search | Date of completion of the search | Examiner |
|---|---|---|
| The Hague | 5 August 2005 | Rydyger, K |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT**
**ON EUROPEAN PATENT APPLICATION NO.**                    EP 05 00 6686

This annex lists the patent family members relating to the patent documents cited in the above-mentioned European search report.
The members are as contained in the European Patent Office EDP file on
The European Patent Office is in no way liable for these particulars which are merely given for the purpose of information.

05-08-2005

| Patent document cited in search report | | Publication date | Patent family member(s) | | Publication date |
|---|---|---|---|---|---|
| JP 10334607 | A | 18-12-1998 | KR<br>US | 273811 B1<br>6079043 A | 15-12-2000<br>20-06-2000 |
| US 6079043 | A | 20-06-2000 | JP<br>KR | 10334607 A<br>273811 B1 | 18-12-1998<br>15-12-2000 |

EPO FORM P0459

For more details about this annex : see Official Journal of the European Patent Office, No. 12/82